(19) Europäisches Patentamt
European Patent Office
Office européen des brevets

(11) **EP 2 069 101 B1**

(12) **EUROPÄISCHE PATENTSCHRIFT**

(45) Veröffentlichungstag und Bekanntmachung des Hinweises auf die Patenterteilung:
**02.05.2018 Patentblatt 2018/18**

(21) Anmeldenummer: **07846491.4**

(22) Anmeldetag: **05.10.2007**

(51) Int Cl.:
**B23K 35/26** (2006.01)   **C22C 13/00** (2006.01)

(86) Internationale Anmeldenummer:
**PCT/EP2007/008635**

(87) Internationale Veröffentlichungsnummer:
**WO 2008/043482 (17.04.2008 Gazette 2008/16)**

(54) **BLEIFREIES WEICHLOT MIT VERBESSERTEN EIGENSCHAFTEN BEI HOHEN TEMPERATUREN**

LEAD-FREE SOFT SOLDER HAVING IMPROVED PROPERTIES AT ELEVATED TEMPERATURES

MÉTAL D'APPORT DE BRASAGE TENDRE SANS PLOMB PRÉSENTANT DES PROPRIÉTÉS AMÉLIORÉES À DES TEMPÉRATURES ÉLEVÉES

(84) Benannte Vertragsstaaten:
**AT BE BG CH CY CZ DE DK EE ES FI FR GB GR HU IE IS IT LI LT LU LV MC MT NL PL PT RO SE SI SK TR**

(30) Priorität: **06.10.2006 DE 102006047764**

(43) Veröffentlichungstag der Anmeldung:
**17.06.2009 Patentblatt 2009/25**

(73) Patentinhaber: **Heraeus Deutschland GmbH & Co. KG**
**63450 Hanau (DE)**

(72) Erfinder:
• **KRAEMER, Winfried**
**63619 Bad Orb (DE)**
• **TRODLER, Joerg**
**63526 Erlensee (DE)**

(74) Vertreter: **Heraeus IP**
**Heraeus Holding GmbH**
**Schutzrechte**
**Heraeusstraße 12-14**
**63450 Hanau (DE)**

(56) Entgegenhaltungen:
**EP-A- 1 231 015      EP-A- 1 623 791**
**WO-A-97/43456       WO-A-03/051572**
**CN-A- 1 346 728      DE-A1-102004 050 441**

**Beschreibung**

Die vorliegende Erfindung betrifft ein Weichlot für Gegenstände, deren Anwendungsbereich bis zu 200°C liegt, insbesondere 150 bis 190°C.

Bei diesen hohen Temperaturen altern Zinn-Silber-Kupfer-(SAC)-Lötstellen besonders schnell durch das Wachstum intermetallischer Phasen. Die Zugfestigkeit ist bei hohen Temperaturen geringer und die Dehngrenze verschlechtert sich durch die Materialermüdung, die einhergehend mit dem Wachstum der intermetallischen Phasen erfolgt.

Gemäß den EU-Richtlinien 2002/96/EG "Waste Electrical and Electronic Equipment" = WEEE und 2002/95/EG "Restriction of the use of certain hazardous substances in electrical and electronic equipment" = RoHS (http://ec.europa.eu/environment/waste/ weee_index.htm) ist die Verwendung bleihaltiger Lote stark beschränkt und im Wesentlichen die Anwendungen bleifreier Lote vorgeschrieben. Als bleifrei gelten demnach Lote mit einem Bleigehalt bis 0,1 Gew.-%.

US 5,938,862 offenbart ein SAC-Weichlot mit 8 bis 10 Gew.-% Indium bei 2,3 Gew.-% Ag und 1 Gew.-% Kupfer. Der hohe Indium-Gehalt macht die Lotlegierungen sehr weich und es treten Deformierungen (Löcher) auf, so dass diese Indiumlegierungen zur Herstellung von Lotkugeln für die Chipherstellung ungeeignet sind.

DE 10 2004 050 441 A1 offenbart den Einsatz von Lanthaniden in Kombination mit Eisenmetallen, um Materialvergröberungen durch thermische Beeinflussung zu verzögern. Es wird angenommen, dass Neodym, welches vorzugsweise als Eisenmetall-Vorlegierung eingebracht wird, durch die Vorlegierung als entsprechende intermetallische Phase definiert wird, da das dort verwendete Mischmetall aufgrund seiner hohen Affinität zu Sauerstoff konventionell nicht legierbar wäre.

EP 1 623 791 A2 beschreibt zur Problematik der Ausbildung von Schlacken, wie sie beispielsweise durch das Einbringen von Neodym erfolgt, ein Verfahren zu deren Abtrennung. Damit können beispielsweise Lote gemäß WO 03/051572 gereinigt werden. WO 03/051572 beschreibt ein Indium aufweisendes SAC-Lot, dem gegebenenfalls Neodym zulegiert ist. Mit 5 bis 20 Gew.-% wird eine nahezu eutektische Legierung erzeugt. Dies hat den Vorteil, dass die Legierung nahezu schlagartig erstarrt und dabei eine glatte Oberfläche ausbildet. Der hohe Silbergehalt führt zu einem hohen Anteil an $Ag_3Sn$-Phasen, die unter Temperaturbelastung weiter wachsen und das Gefüge vergröbern würden.

WO 03/051572 A1 offenbart ein bleifreies Weichlot auf Basis einer SAC-Legierung mit 0,8 bis 1,2 Gew.-% Indium und 0,01 bis 0,2 Gew.-% Neodym. Dieses Weichlot soll die Ausbildung grober Zinn-Dentride vermeiden und nach dem Aufschmelzen eine glatte und homogene Oberfläche des Lotes gewährleisten. Weiterhin soll das Lot eine möglichst hohe Wechselfestigkeit besitzen, so dass mit diesem Weichlot selbst Werkstoffe mit sehr unterschiedlichen thermischen Ausdehnungskoeffizienten miteinander gefügt werden können.

WO 97/43456 weist auf die Problematik von Materialermüdung durch Temperaturwechsel im Automobilbereich hin. Es wird ein bleifreies Weichlot aus 68,2 bis 91,8 Gew.-% Zinn, 3,2 bis 3,8 Gew.-% Silber und 5 bis 5,5 Gew.-% Indium beschrieben, welches optional bis zu 3 Gew.-% Wismut und bis zu 1,5 Gew.-% Kupfer aufweist. Als Beispiel ist eine Legierung mit 89,8 Gew.-% Zinn, 3,7 Gew.-% Silber, 5 Gew.-% Indium und 1,5 Gew.-% Kupfer aufgeführt.

CN-A-1 346 728 offenbart ein bleifreies Weichlot auf Basis einer Sn-In-Ag-Legierung, enthaltend 0,1-7,5% In, 0,1-5% Ag, 0,1-1% Cu und eine Dotierung mit Nd.

Die Aufgabe der vorliegenden Erfindung liegt darin, der Materialermüdung entgegen zu treten, die bei Temperaturen bis 200°C, insbesondere im Bereich zwischen 150 und 190°C, auftritt.

Der Schmelzpunkt des Lotes soll wenigstens 10°C, besser 20°C über der maximalen Anwendungstemperatur liegen.

Die Lösung der Aufgabe erfolgt mit den Merkmalen der unabhängigen Ansprüche. Die abhängigen Ansprüche beschreiben bevorzugte Ausführungen.

Maßgeblich für die vorliegende Erfindung ist, dass ein Weichlot auf Basis einer Zinn-Indium-Silber-Legierung die Ausbildung und das Wachsen intermetallischer Phasen hemmt. Erfindungsgemäß werden die Massenanteile der Komponenten Zinn, Indium,

Silber und gegebenenfalls Kupfer so gewählt, dass schon aufgrund dieser Zusammensetzung eine geringe Neigung zur Ausbildung und zum Wachstum intermetallischer Phasen besteht. Darüber hinaus wird die Ausbildung von intermetallischen $Ag_3Sn$-Phasen gehemmt, insbesondere deren zu Materialvergröberung führendes Wachstum in einer bevorzugten Richtung.

Erfindungsgemäß wurde erkannt, dass die im Stand der Technik zur Kornverfeinerung vorgesehenen Lanthanide zwar beim Erstarren des Lotes anwendbar sind, die Loteigenschaften aber bei Lanthanid-, insbesondere bei Nd-Konzentrationen von über 100 ppm

in Mitleidenschaft gezogen werden. Die angewendeten Mengen liegen stets über der Löslichkeitsgrenze von Lanthaniden, insbesondere Neodym in Zinn, so dass die Lanthanide, insbesondere das Neodym stets in intermetallischen Phasen vorliegen. Intermetallische Phasen sind jedoch oxidationsanfällig, insbesondere bei hohen Anwendungstemperaturen und würden deshalb bei hohen Anwendungstemperaturen zu vielerlei Problemen führen, weshalb derartige Phasen für Lote zu vermeiden sind, die Temperaturen von über 150°C ausgesetzt werden.

Erfindungsgemäß wird einerseits die Ausbildung metallischer Phasen gering gehalten und andererseits die Kristallisation der intermetallischen Phasen modifiziert. Höhere Kupfer- oder Silberanteile erhöhen die Bildung von intermetallischen Phasen. Maßgeblich ist dabei, dass zwischen 1 und 8 Gew.-% Indium, insbesondere zwischen 1,5 und 5 Gew.-% Indium, die Ausbildung einer $Cu_3Sn$-Phase bei der Applikation des Lots auf einer Cu-Oberfläche deutlich beschränkt wird. Weiterhin maßgeblich ist, dass das Kristallisationswachstum modifiziert. Beide Effekte verlangsamen die Materialermüdung bei hohen

Temperaturen; insbesondere, sofern der Silbergehalt auf maximal 3,5, insbesondere

3 Gew.-% beschränkt wird. Zur Modifikation des Kristallwachstums der $Ag_3Sn$-Phasen wird erfindungsgemäß ein Kristallisations-Modifikator, Neodym, verwendet. Neodym kann als Modifikator in einer Menge unterhalb der ICP-Nachweisgrenze von

30 ppm das Kristallwachstum nachhaltig modifizieren. Neodym braucht deshalb nur in Mengen von unter 100 ppm, insbesondere unter 30 ppm, im Weichlot dotiert sein. Sofern das Neodym aufgrund geringer Konzentration in der Matrix gelöst ist, hemmt es die Ausbildung intermetallischer Phasen, so dass diese, wenn überhaupt sich sternförmig ausbilden. Es wird vermutet, dass das in der Matrix gelöste Neodym bei einer Neodym-Konzentration von über 100 ppm durch die entstehenden intermetallischen Neodym-Phasen aufgesaugt wird und deshalb bei höheren Konzentrationen in der Nähe der intermetallischen Neodym-Phasen nicht mehr in der Matrix gelöst ist. Es wird angenommen, dass sich deshalb die Ausbildung intermetallischer Phasen bei einer Neodym-Konzentration über 100 ppm mit der Zunahme der Neodym-Konzentration erhöht statt erniedrigt.

Die Modifizierung des Kristallwachstums durch Neodym liegt darin, dass bei Temperaturen über 150°C im erstarrten Lot, d.h. unterhalb dessen Schmelzpunkt statt grober Kristallplatten odernadeln fein verzweigte Kristalle entstehen.

Dieser Effekt ist bei der zunehmenden Miniaturisierung der Lötverbindungen, z.B. der ChipHerstellung, insbesondere beim Waferbumping, von großer Bedeutung. Besonders unter Betriebsbedingungen bei Temperaturen über 150°C werden durch das Phasenwachstum der $Cu_3Sn$- bzw. $Cu_6Sn_5$-Phasen in den Grenzflächen zunehmende Anteile von Sn aus der Lötverbindung gebunden. Der sich dadurch zwangsweise erhöhende Ag-Anteil im verbliebenen Lot führt bei der Überschreitung des oben genannten Schwellwertes von 3,0 Gew.-% zu einem starken Kristallwachstum der $Ag_3Sn$-Phasen.

Durch die platten- bzw. nadelförmige Ausbildung der $Ag_3Sn$-Phasen ist es möglich, dass die Phasen aus der Lötverbindung herauswachsen und zu Kurzschlüssen führen. Durch die Nd-Dotierung wird dies verhindert.

Fein verzweigtes Kristallwachstum der $Ag_3Sn$-Phasen gibt daher einen Hinweis auf Neodym, dessen Anwesenheit in homöopathischen Mengen unterhalb der Nachweisgrenze von 30 ppm ausreicht. Maßgeblich ist aber, dass das erfindungsgemäße Weichlot mit einem Modifikator, Neodym, dotiert ist. Die natürlichen Verunreinigungen reichen nicht aus. Neodym ist nur bis zu etwa 100 ppm verträglich. Die Löslichkeitsgrenze von Neodym in Zinn liegt unter 100 ppm. Darüber scheidet sich Neodym in intermetallischen Zinn-Neodym-Phasen aus. Größere Mengen an Neodym verschlechtern die Legierung durch Ausscheiden von oxidierten SnNd-Phasen. 0,05 bis 0,2 Gew.-% Neodym führen zu einer Oxidhaut auf der Lotoberfläche, bedingt durch die Oxidation von Neodym unter atmosphärischen Bedingungen. Um Neodym in einer Konzentration von 0,01 Gew.-% in einer Schmelze zu halten, wären reduzierende Bedingungen oder das Anlegen eines Vakuums erforderlich. Eine Legierung mit 0,2 Gew.-% Neodym ist mit konventionellen Herstellverfahren nicht zu Lotpulver verarbeitbar und fördert durch oxidierte Einschlüsse in der Grenzfläche der Lötstelle die Rissbildung.

Ebenfalls sehr maßgeblich ist die Dosierung von Indium. Indium scheint maßgeblich das Wachstum der $Cu_3Sn$-Phase zu hemmen. Hierzu sind zwischen 1 bis 2 Gew.-% Indium erforderlich, um die Ausbildung einer $Cu_3Sn$-Phase relevant zu hemmen. Bei 1 % Indium und erst recht darunter ähnelt das Phasenwachstum der $Cu_3Sn$-Phase dem eines reinen SAC-Weichlots (Sn, Ag, Cu). Bei 1,75 Gew.-% ist ein deutlich geringeres Phasenwachstum der $Cu_3Sn$-Phase gefunden worden und damit einhergehend eine längere Hochtemperaturbeständigkeit. Indium ist die teuerste aller Komponenten und wird bereits aus diesem Grunde möglichst sparsam eingesetzt. So ist der im Bereich zwischen 5 bis 8 Gew.-% Indium teuer eingekaufte Effekt relativ gering. Über 8 % Indium wird der Schmelzpunkt des Weichlots zu niedrig für die mit dem erfindungsgemäßen Weichlot bezweckten Hochtemperaturanwendungen. Die Zugfestigkeit steigt in Abhängigkeit vom Indiumgehalt, weshalb unter diesem Aspekt ein Indiumgehalt zwischen 4 und 8 Gew.-%, gerechtfertigt werden kann.

Die erfindungsgemäßen Weichlote haben eine ausgezeichnete Temperaturwechsel-beständigkeit im Einsatz bei Temperaturen ab 150°C.

Vorzugsweise liegt der Schmelzpunkt erfindungsgemäßer Lote über 210°C, inbesondere über 215°C.

Die zu erwartende mechanische Festigkeit einer erfindungsgemäßen Lotlegierung wird mit den folgenden Funktionen hinreichend genau beschrieben:

Maximale Zugfestigkeit: Rm in MPa

$$Rm = 16 \text{ MPa} + 4{,}3 \text{ MPa Ag [Gew.\%]} + 4{,}4 \text{ MPa In [Gew.\%]} + 10 \text{ MPa Cu [Gew.\%]}$$

Dehngrenze $Rp_{0,2}$ in Mpa

$$Rp0{,}2 = 7 \text{ Mpa} + 2{,}2 \text{ MPa Ag [Gew.\%]} + 4{,}8 \text{ MPa In [Gew.\%]}$$

Die Festigkeiten der Lotlegierungen wurden an gegossenen Zugprüfkörpern mit einem Probendurchmesser von 3,2 mm und einer Messlänge von 15 mm bestimmt. Die Prüfkörper wurden vor der Prüfung 6 Wochen bei Raumtemperatur gelagert.

Der Gehalt an Silber sollte über 0,5 Gew.-%, vorzugsweise über 1 Gew.-% betragen, damit der Schmelzpunkt des Lots nicht zu hoch ist und nicht zu viel Indium zur Schmelzpunkterniedrigung benötigt wird. Oberhalb von 3,5 Gew.-% Silber wird der Anteil der $Ag_3Sn$-Phasen unerwünscht hoch. Silber sollte deshalb in einer Menge zwischen 0,5 und 3,5 Gew.-%, insbesondere zwischen 1 und 3 Gew.-% eingesetzt werden. Optional kann Kupfer bis zu 1 Gew.-% enthalten sein. Bei Anteilen über 1 Gew.-% bildet Cu vermehrt die unerwünschte $Cu_6Sn_5$-Phase, die bei hohen Temperaturen unerwünscht schnell wächst.

Der Gehalt an Zinn sollte zwischen 88 und 98,5 Gew.-% liegen. Unter 88 Gew.-% wird der Schmelzpunkt zu niedrig für Hochtemperaturanwendungen. Weiterhin werden die Anteile an Ag- und Cu-Phasen erhöht oder unnötig viel Indium verbraucht. Über 98,5 Gew.-% wird der Schmelzpunkt zu hoch und die Zugfestigkeit zu gering.

Das erfindungsgemäße Weichlot verträgt bis zu 1 % Additive, insbesondere Ni, Fe, Co, Mn, Cr, Mo oder Ge und übliche Verunreinigungen. In Spuren weit unter 1 % kann Nd auch als kostengünstige Seltenerdmetallmischung (z.B. in Kombination mit Ce, La oder Pr) zugesetzt werden. Eine eventuell notwendige Anpassung von Schmelzpunkt und Festigkeit des Lotes ist durch Zusatz von bis zu 3 % Sb oder Bi oder Ga möglich, um teures In einzusparen. Insgesamt soll die Summe der Elemente Sb, Bi und Ga 3 Gew.-% nicht überschreiten. Da bezüglich Wismut die von der Bleianwendung bekannten Probleme auftreten könnten, wird empfohlen, Wismut zu vermeiden, zumindest dessen Gehalt unter 0,1 Gew.-% zu belassen.

Die erfindungsgemäßen Lote ermöglichen eine zuverlässigere Elektronik bei Einsatztemperaturen der Elektronik im Bereich zwischen 140 und 200°C, insbesondere zwischen 150 und 190°C oder hohen Temperaturwechsel-Bedingungen. Die erfindungsgemäßen Lote erhöhen die Zuverlässigkeit der Leistungselektronik und der Hochtemperaturanwendungen, insbesondere Leistungselektronik in Hochtemperaturanwendungen. Als Beispiele für die Leistungselektronik seien genannt: DCB (direct copper bonding), COB (chip on board), Hybridschaltungen, Halbleiter, Waferbumping, SIP (system in packaging) und MCM (multi chip module), insbesondere stack-package. Die Gefahr von elektrischen Kurzschlüssen aufgrund Wachstums von $Ag_3Sn$-Phasen bei kurz beabstandeten Lotverbindungen wie beim Waferbumping wird mit erfindungsgemäßen Loten erheblich reduziert.

Der Temperaturbereich zwischen 140 bis 200°C, insbesondere 150 bis 190°C, ist für elektronische Lotverbindungen im Maschinenbau, insbesondere Fahrzeugbau, von erheblicher Bedeutung, weshalb mit erfindungsgemäßen Loten im Maschinenbau und Fahrzeugbau für eine erhöhte Sicherheit bezüglich der Elektronik gesorgt wird. Insbesondere ist in diesem Bereich neben der Temperaturbeanspruchung auch die Temperaturwechsel-Beständigkeit von Bedeutung und mit den erfindungsgemäßen Loten verbessert. Die mit den erfindungsgemäßen Loten verbesserte Sicherheit im Hochtemperaturbereich ist besonders wichtig für die Bereiche Automotive, Industrieelektronik, Schienenfahrzeuge und Raumfahrttechnik. Speziell die Elektronik im Bereich von Motoren, Triebwerken oder Bremsen ist bereits äußerer Temperaturbeanspruchung ausgesetzt und soll trotzdem eine maximale Zuverlässigkeit aufweisen, wobei im Falle von Leistungselektronik noch die durch die Elektronik erzeugte Wärme die Zuverlässigkeit beeinträchtigt. Die erfindungsgemäßen Lote werden maßgeblich zur Linderung der Problematik in diesen technischen Gebieten beitragen. Weiterhin werden die erfindungsgemäßen Lote die Zuverlässigkeit von Sonnenstrahlen ausgesetzter Elektronik, insbesondere direkter Sonnenstrahlung ausgesetzter Elektronik, aber auch durch indirekte Sonnenstrahlung belasteter Elektronik zu erhöhter Sicherheit verhelfen.

Im Folgenden wird die Erfindung anhand von Beispielen gemäß Tabelle 1 und den Abbildungen verdeutlicht.

## Tabelle 1

| Leg. Nr. | | Sn | Ag | Cu | In | Ga | Nd | Schmelzintervall | | | Festigkeit Guß | |
| --- | --- | --- | --- | --- | --- | --- | --- | --- | --- | --- | --- | --- |
| | | | | | | | | Liquidus [°C] | Solidus [°C] | Unterkühlung | $Rp_{0,2}$ [Mpa] | Rm [Mpa] |
| Vergleich | 1 | 96,500 | 3,50 | | | | | 221 | 221 | | 19 | 32 |
| Vergleich | 2 | 96,500 | 3,00 | 0,50 | | | | 219,4 | 216,2 | | 18 | 35 |
| Vergleich | 6 | 95,700 | 3,80 | 0,50 | | | | 216,7 | 215,8 | | | |
| Vergleich | 7 | 95,500 | 3,80 | 0,70 | | | | | | | 19 | 41 |
| Vergleich | 8 | 95,500 | 4,00 | 0,50 | | | | 217,9 | 216,8 | | 17,5 | 37,5 |
| Vergleich | 9 | 91,500 | 4,00 | 0,50 | 4,00 | | | 210 | 206,5 | | | |
| Vergleich | 10 | 88,500 | 4,00 | 0,50 | 7,00 | | | 205,1 | 202,2 | | | |
| Vergleich | 11 | 92,300 | 5,50 | 1,00 | 1,00 | | 0,200 | 215,1 | eutekt. | | | |
| Referenzbeispiel | 1 | 95,490 | 2,00 | 0,50 | 2,00 | | 0,010 | 217,8 | 209,8 | + | | |
| Beispiel | 5 | 94,995 | 2,50 | 0,50 | 2,00 | | 0,005 | 216,1 | 210,3 | + | | |
| Beispiel | 6 | 94,495 | 3,00 | 0,50 | 2,00 | | 0,005 | 214,8 | 211,2 | + | | |
| Referenzeispiel | 7 | 93,695 | 3,80 | 0,50 | 2,00 | | 0,005 | 213,5 | 211,3 | + | | |
| Beispiel | 8 | 94,745 | 2,50 | 0,75 | 2,00 | | 0,005 | 216,8 | 209,8 | + | 24,5 | 41,3 |
| Referenzbeispiel | 9 | 97,245 | 0,00 | 0,75 | 2,00 | | 0,005 | 223,8 | 216,9 | + | 20,0 | 33,4 |
| Beispiel | 10 | 95,500 | 2,50 | 0,00 | 2,00 | | <0,003 | 219,2 | 213,4 | + | 20,2 | 33,0 |
| Vergleich | 3 | 96,990 | 2,50 | 0,50 | 0,00 | | 0,010 | 224,1 | 216,5 | + | 18,3 | 32,5 |
| Vergleich | 4 | 95,990 | 2,50 | 0,50 | 1,00 | | 0,010 | 220,5 | 211,0 | + | 19,9 | 37,0 |
| Vergleich | 5 | 95,000 | 2,50 | 0,50 | 2,00 | | 0,000 | 217,2 | 209,5 | - | 24,4 | 41,1 |
| Referenzbeispiel | 2 | 93,990 | 2,50 | 0,50 | 3,00 | | 0,010 | 216,3 | 206,7 | + | 27,4 | 43,4 |
| Beispiel | 3 | 92,995 | 2,50 | 0,50 | 4,00 | | 0,005 | 217,1 | 206,2 | + | 36,3 | 47,6 |
| Beispiel | 4 | 89,950 | 2,50 | 0,50 | 7,00 | | 0,050 | 207,3 | 200,4 | + | 50,6 | 64,5 |
| Referenzbeispiel | 11 | 94,500 | 2,50 | 0,50 | 2,50 | | 0,000 | 215,4 | 208,9 | - | 26,4 | 44,8 |
| Beispiel | 12 | 95,250 | 2,50 | 0,50 | 1,75 | | <0,003 | 218,2 | 209,8 | - | 21,0 | 36,7 |
| Referenzbeispiel | 13 | 95,000 | 2,80 | 0,20 | 2,00 | | 0,000 | 218,3 | 206,3 | - | 26,6 | 42,5 |
| Beispiel | 14 | 94,695 | 2,70 | 0,40 | 2,20 | | 0,005 | 217,7 | 209,4 | + | 25,2 | 40,6 |
| Beispiel | 15 | 94,695 | 2,50 | 0,50 | 2,00 | 0,30 | 0,005 | 215,8 | 207,8 | + | 27,6 | 44,1 |
| Beispiel | 16 | 94,195 | 2,50 | 0,50 | 2,00 | 0,80 | 0,005 | 214,1 | 203,1 | + | 29,7 | 46,8 |

Hierzu visualisiert

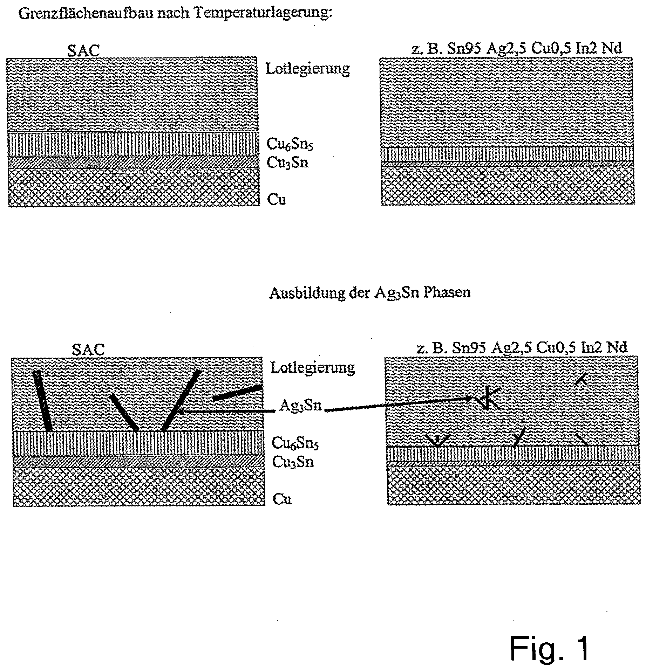

Fig. 1 die schematische Struktur bezüglich der Ausbildung von $Ag_3Sn$-Phasen einer SAC-Lötstelle auf Kupferuntergrund im Vergleich zu einer erfindungsgemäß In aufweisenden und mit Nd dotierten SAC-Lötstelle;

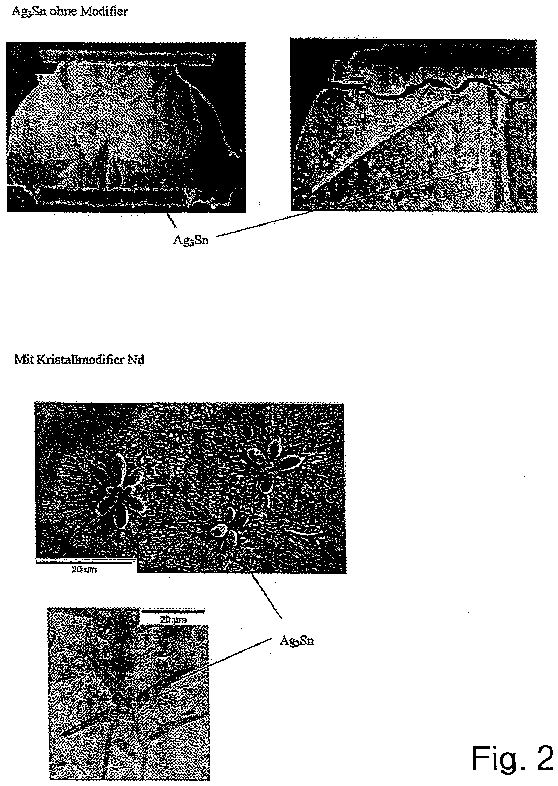

Fig. 2 die mit erfindungsgemäßen Loten ausgebildeten Ag3Sn-Phasen im Vergleich zu bisher ausgebildeten Ag3Sn-Phasen anhand von Fotos;

Fig. 3 die Abhängigkeit der Zugfestigkeit vom Indiumgehalt;

Fig. 4 die Abhängigkeit des Schmelzintervalls vom Indiumgehalt;

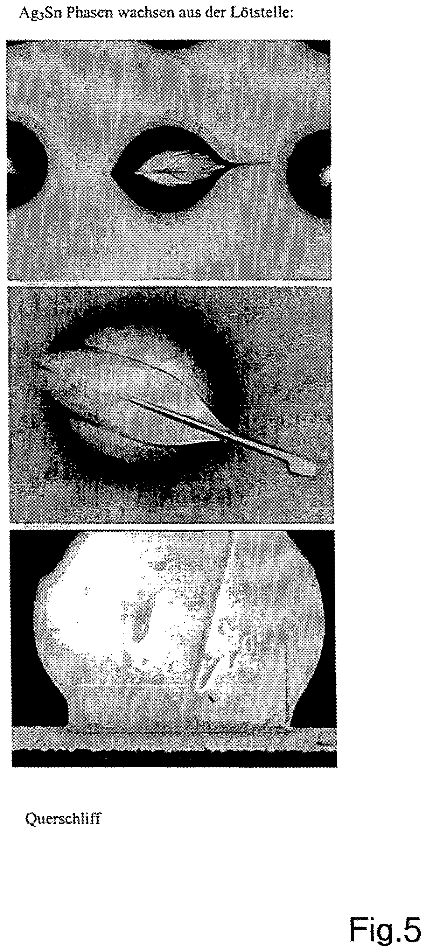

Fig. 5 ein Vergleichsbeispiel mit einer zum Kurzschluss führenden Ausbildung einer intermetallischen Phase; und

Fig. 6 die Oxidationsanfälligkeit einer intermetallischen Phase, die Neodym aufweist.

Ausführungsbeispiel eines Herstellungsverfahrens

Zur Herstellung einer erfindungsgemäßen Lotlegierung ist es vorteilhaft, die Nd-Dotierung über eine Vorlegierung vorzunehmen.

Durch die üblicherweise recht niedrigen Schmelztemperaturen bei der Lotpulver-Herstellung von < 500°C besteht die Gefahr, dass elementar eingesetztes Nd als reines Metall oder Seltenerdmetallmischung durch die niedrige Dichte auf dem vorgeschmolzenen Lot aufschwimmt und sofort oxidiert wird. In der Form von Neodymoxid ist es nicht mehr wirksam und reichert sich in der Schlacke an.

Um dies zu unterdrücken, wird das Neodym über eine Vorlegierung mit einer oder mehreren Komponenten der Lotlegierung zudotiert. Hierdurch wird eine Oxidation des bereits schon legierten Neodyms vermieden und eine gleichmäßige Verteilung des Kristall-Modifikators erreicht.

Als Vorlegierung eignen sich z. B.:

- Sn Nd 2-10
- Cu Nd 10-20
- AgNd 10-20
- Ag Cu 10-40 Nd 5-15

(Angaben der Konzentrationsbereiche in Gew.-%)

Diese Vorlegierungen lassen sich leicht mit geeigneten Schmelzverfahren herstellen. Es hat sich bewährt, das Neodym bei Temperaturen über 800 °C zu legieren, um eine homogene Verteilung zu erreichen, und dass die fertige Vorlegierung einen Schmelzpunkt unter 1000°C, vorzugsweise unter 900°C hat. Dies gewährleistet ein problemloses Lösen der Vorlegierung in der Lotschmelze bei < 500°C.

Vergleichsbeispiel 1

Sn 96,5, Ag 3,5 hat eine Dehngrenze Rp 0,2 von 19 MPa und eine Zugfestigkeit von 32 MPa. Diese Legierung neigt stark zum Wachstum von $Ag_3Sn$-Phasen und zeigt deshalb bei Temperaturen ab 150°C starke Materialermüdung. Mit zunehmendem Silbergehalt wird die Ausbildung der $Ag_3Sn$-Phasen begünstigt.

Vergleichsbeispiel 2

Sn 96,5, Ag 3, Cu 0,5 hat eine Dehngrenze von 18 MPa und eine Zugfestigkeit von 35 MPa. Dieses Weichlot bildet wie das von Vergleichsbeispiel 1 beim Lötprozess eine ausgeprägte $Cu_3Sn$-Schicht auf der Oberfläche einer Kupferbasis. Die intermetallische $Cu_3Sn$-Phase wächst und versprödet die Grenzfläche zum Kupfer bei Temperaturen über 150°C und führt zur Materialermüdung der Lotverbindung.

Vergleichsbeispiel 3

Sn 96,99, Ag 2,5, Cu 0,5, Nd 0,01 hat eine Dehngrenze von 18,3 MPa und eine Zugfestigkeit von 32,5. Beim Aufschmelzen dieser Legierung auf eine Kupferbahn bildet sich ebenfalls $Cu_3Sn$, welches bei Temperaturen über 150°C anwächst.

Gemäß Vergleichsbeispiel 4 bewirkt eine Zugabe von 1 Gew.-% Indium gegenüber Vergleichsbeispiel 3 ein Ansteigen der Dehngrenze auf 19,9 und ein Ansteigen der Zugfestigkeit auf 37,0. Bezüglich der Ausbildung der $Cu_3Sn$-Phase und der mit dieser Phase bei Temperaturen über 150°C einhergehenden Materialermüdung besteht jedoch gegenüber Vergleichsbeispiel 3 kein maßgeblicher Unterschied.

Vergleichsbeispiel 4

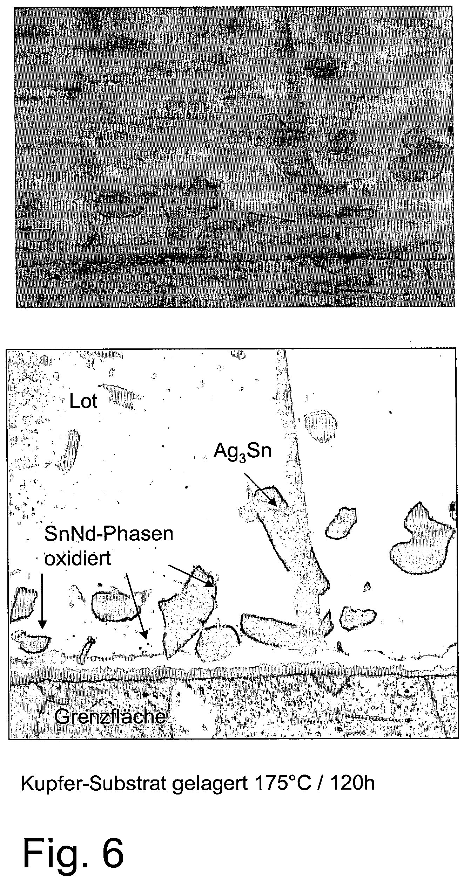

Ein Weichlot mit einem Neodymgehalt, der eine intermetallische Phase ausbildet, altert schnell. Figur 6 zeigt eine das Neodym enthaltende intermetallische Phase, die infolge einer Auslagerung bei 175°C über einen Zeitraum von 120 Stunden an ihren Grenzflächen vollständig oxidiert wurde und auf diese Weise eine maßgebliche Materialermüdung darstellt, die Ausgangspunkt für weitere Materialverschlechterung ist.

Referenzbeispiel 1

Sn 95,49, Ag 2, Cu 0,5, In 2, Nd 0,01 zeigt neben weiter verbesserten mechanischen Eigenschaften gegenüber Vergleichsbeispiel 4 eine unterdrückte Ausbildung der $Cu_3Sn$-Phase und ein geringeres Anwachsen derselben bei Temperaturen über 150°C. Mit diesem Referenz-Beispiel wird damit bei hervorragenden mechanischen Eigenschaften die Materialermüdung drastisch verlangsamt.

Unterbleibt die Dotierung mit Neodym aus Referenzbeispiel 1 gemäß Vergleichsbeispiel 5, ist zwar die Aus-

bildung der $Cu_3Sn$-Phase anfänglich gering, jedoch neigt die $Ag_3Sn$-Phase bei Temperaturen über 150°C zu Wachstum und Ausbildung von groben Platten oder Nadeln und führt daher zu einer nicht hinnehmbaren Materialermüdung und der Gefahr der Kurzschlussbildung durch das Kristallwachstum von $Ag_3Sn$.

Referenzbeispiel 2 mit einer Erhöhung der Indiumkonzentration gegenüber Referenzbeispiel 1 um 1 % bewirkt weiter verbesserte mechanische Eigenschaften. Die Ausbildung der $Cu_3Sn$-Phase beim Löten auf eine Kupferbahn ist gegenüber Referenzbeispiel 1 weiter reduziert und die Materialermüdung bei Temperaturen über 150°C nochmals verringert.

Eine weitere Steigerung um 1 Gew.-% Indium gemäß Beispiel 3 bewirkt neben nochmals verbesserten mechanischen Eigenschaften keine relevante Verringerung bei der Ausbildung der $Cu_3Sn$-Phase gegenüber Referenzbeispiel 2. Die Materialermüdung bei Temperaturen über 150°C ist gegenüber Referenzbeispiel 2 reduziert.

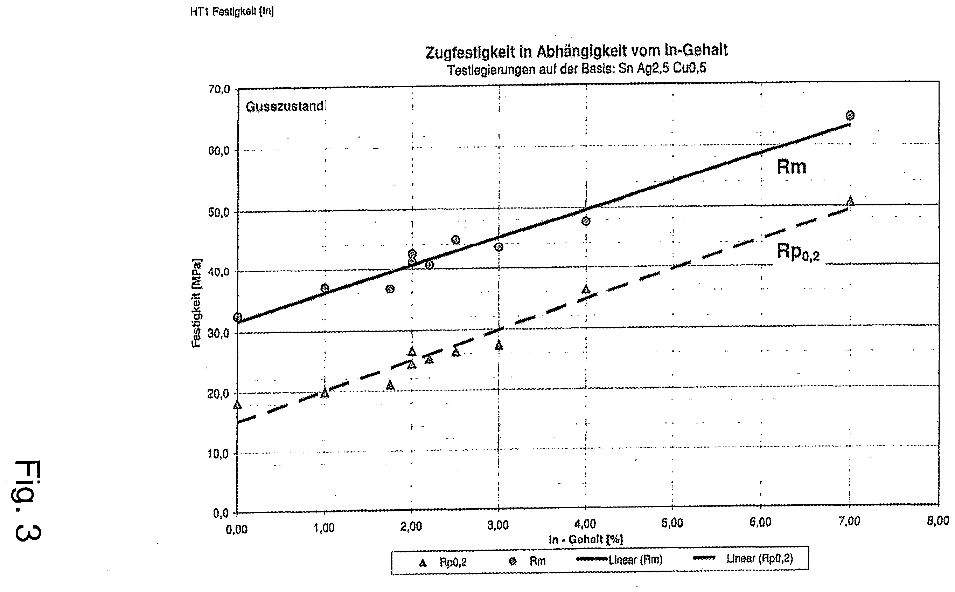

Mit einer weiteren Steigerung von 3 Gew.-% Indium gegenüber Beispiel 3 werden weiter deutlich verbesserte mechanische Eigenschaften gegenüber Beispiel 3 erreicht. Es besteht jedoch keine signifikante Verringerung bei der Ausbildung der $Cu_3Sn$-Phase beim Auflöten auf einer Kupferbahn gegenüber Referenzbeispiel 2 und Beispiel 3. Es besteht zwar noch eine geringe Verbesserung hinsichtlich der Materialermüdung bei Temperaturen über 150°C gegenüber Beispiel 3. Dafür ist aber der Solidus des Schmelzintervalls bereits auf 200,4°C abgesenkt. Abbildung 3 zeigt die Abhängigkeit des Schmelzintervalls vom Indiumgehalt eines Weichlots auf Basis von Zinn mit 2,5 Gew.-% Silber und 0,5 Gew.-% Kupfer.

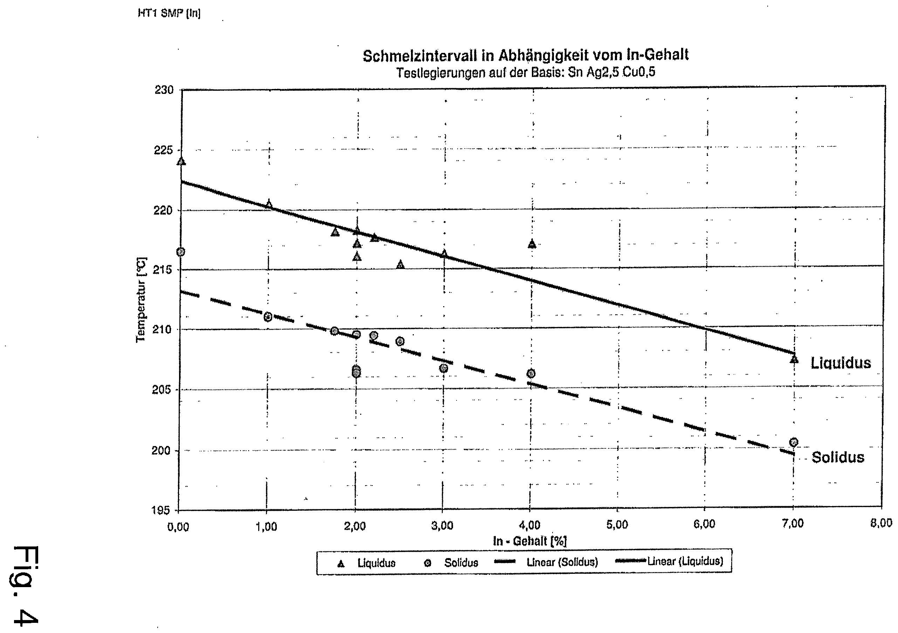

Abbildung 4 zeigt den entsprechenden Anstieg in der Zugfestigkeit.

Anhand von Tabelle 2 wird im Folgenden erklärt, wie das Anwachsen der $Cu_3Sn$-Phasen mit In unterdrückt wird. Die verbesserte Hochtemperaturbeständigkeit ist durch das gehemmte Phasenwachstum der $Cu_3Sn$-Phasen zu erklären.

Ohne In ist das Verhältnis der $CU_3Sn$ / $Cu_6Sn_5$-Phasen nach einer Temperaturlagerung von 175°C/120h ca. 1/2. Mit 2 % In reduziert sich das Verhältnis auf 1/3, wobei die Gesamtstärke der CuSn-Phasen in der Grenzfläche um ca. 45 % reduziert wird.

Tabelle 2: Schichtstärke der CuSn-Phasen nach Lagerung 175°C / 120h

| Legierung | $Cu_3Sn$ | $Cu_6Sn_5$ | Gesamt | Verhältnis |
|---|---|---|---|---|
| Sn95,5 Ag4 Cu0,5 | 5 $\mu$m | 10 $\mu$m | 15 $\mu$m | 0,33 |
| Sn92,8 Ag5 Cu1 In1 Nd0,2 | 4 $\mu$m | 8 $\mu$m | 12 $\mu$m | 0,33 |
| Sn94,995 Ag2,5 Cu0,5 ,In2 Nd0,005 | 2 $\mu$m | 6 $\mu$m | 8 $\mu$m | 0,25 |
| Sn91,5 Ag4 Cu0,5 In4 | 1,5 $\mu$m | 5,5 $\mu$m | 7 $\mu$m | 0,21 |
| Sn88,5 Ag4 Cu0,5 In7 | 1 $\mu$m | 5 $\mu$m | 6 $\mu$m | 0,17 |

Die verbesserte Hochtemperaturbeständigkeit findet ihre Erklärung in den Eigenschaften der CuSn-Phasen. Die Härte von $Cu_3Sn$ beträgt 320 HV10 und die Phase ist sehr spröde und rissanfällig, während die Härte von $Cu_6Sn5$ "nur" 105 HV10 beträgt und deutlich geringere Sprödigkeit aufweist. Zur besseren Charakterisierung der entstehenden $Cu_3Sn$- und $Cu_6Sn_5$-Phasen wurde die Härte an den schmelzmetallurgisch hergestellten Phasen bestimmt. Diese Verfahrensweise wurde gewählt, da die Härtemessung am metallographischen Schliff in den Grenzflächen der gelöteten Proben bedingt durch die geringe Schichtstärke von wenigen $\mu$m nur ungenaue Ergebnisse liefert.

Es ist somit ausschlaggebend für die Hochtemperaturzuverlässigkeit, wie stark die spröde $Cu_3Sn$-Phase sich unter der Temperaturbeanspruchung ausbildet. Je langsamer das Phasenwachstum und je dünner die Schichtstärke der spröden $Cu_3Sn$-Phase ist, umso besser können Spannungen in den Grenzflächen abgebaut werden und dadurch die Hochtemperaturzuverlässigkeit gesteigert werden.

Ein weiterer Vorteil besteht darin, dass sich durch das reduzierte Phasenwachstum die Cu-Leiterbahnen bei erhöhten Betriebstemperaturen deutlich verzögert in CuSn-Phasen umsetzen, auch Ablegieren genannt. Wenn die Cu-Schichtstärke in den beloteten Flächen der Leiterbahnen zu gering wird, lösen sich diese von dem Trägermaterial und es kommt zum elektrischen Ausfall des Bauteils.


**Patentansprüche**

1. Bleifreies Weichlot auf Basis einer Sn-In-Ag-Lotlegierung bestehend aus

- zwischen 88 bis 98,5 Gew.-% Sn,
- zwischen 1 bis 8 Gew.-% In,
- zwischen 0,5 bis 3,5 Gew.-% Ag,
- zwischen 0 bis 1 Gew.-% Cu,
- zwischen 0 bis 3 Gew.-% Ga, Sb, Bi insgesamt,
- bis zu 1 Gewichts-% Additiven in Form von Ni, Fe, Co, Mn, Cr, Mo oder Ge oder Verunreinigungen,
- und einer Dotierung mit einem das Wachstum intermetallischer Phasen im erstarrten Lot hemmenden Kristallisations-Modifikator in Form von < 100 ppm Neodym.

2. Weichlot nach Anspruch 1, **dadurch gekennzeichnet, dass** es zwischen 1,5 und 5 Gew.-% Indium aufweist.

3. Weichlot nach einem der Ansprüche 1 oder 2, **dadurch gekennzeichnet, dass** es zwischen 1 und 3 Gew.-% Silber aufweist.

4. Weichlot nach einem der Ansprüche 1 bis 3, **dadurch gekennzeichnet, dass** es eine Schmelztemperatur von über 210°C aufweist.

5. Weichlot nach einem der Ansprüche 1 bis 4, **dadurch gekennzeichnet, dass** die Ausbildung von $Ag_3Sn$-Phasen unter Temperaturbelastung sternförmig erfolgt.

6. Weichlot nach einem der Ansprüche 1 bis 5, **dadurch gekennzeichnet, dass** der Kristallisations-Modifikator in der Matrix gelöst ist.

7. Verfahren zur Herstellung eines Weichlotes nach einem der Ansprüche 1 bis 6, **dadurch gekennzeichnet, dass** Nd mit einem der Bestandteile des Sn-In-Ag-Lotes als Vorlegierung angefertigt wird, die in den restlichen Bestandteilen verdünnt wird.

8. Verwendung eines Weichlotes nach einem der Ansprüche 1 bis 6 in der Waferbumping- Technik.

9. Verwendung einer Lotstelle aus einem Weichlot nach einem der Ansprüche 1 bis 3 bei Gebrauchstemperaturen zwischen 140 und 200°C, insbesondere zwischen 150 und 190°C.

**Claims**

1. Lead-free soft solder based on an Sn-In-Ag solder alloy
consisting of

- from 88 to 98.5 wt.% Sn;
- from 1 to 8 wt.% In;
- from 0.5 to 3.5 wt.% Ag;
- from 0 to 1 wt.% Cu;
- from 0 to 3 wt.% Ga, Sb, Bi total;
- up to 1 wt.% of additives in the form of Ni, Fe, Co, Mn, Cr, Mo or Ge or impurities;
- and a doping by a crystallisation modifier that inhibits the growth of intermetallic phases in the solidified solder in the form of < 100 ppm of neodymium.

2. Soft solder according to claim 1, **characterised in that**
the soft solder comprises between 1.5 and 5 wt.% of indium.

3. Soft solder according to either one of the claims 1 or 2, **characterised in that** the soft solder comprises between 1 and 3 wt.% of silver.

4. Soft solder according to any one of the claims 1 to 3, **characterised in that** the soft solder has a melting temperature above 210°C.

5. Soft solder according to any one of the claims 1 to 4, **characterised in that** the formation of $Ag_3Sn$ phases under temperature stress takes place in a star-shaped manner.

**6.** Soft solder according to any one of the claims 1 to 5, **characterised in that** the crystallisation modifier is dissolved in the matrix.

**7.** Method for the production of a soft solder according to any one of the claims 1 to 6, **characterised in that** Nd and one of the components of the Sn-In-Ag solder are prepared as a pre-alloy that is being diluted in the remaining components.

**8.** Use of a soft solder according to any one of the claims 1 to 6 in the wafer bumping technology.

**9.** Use of a soldering point made of a soft solder according to any one of the claims 1 to 3 at usage temperatures between 140 and 200°C, in particular between 150 and 190°C.

**Revendications**

**1.** Métal d'apport de brasage tendre sans plomb à base d'un alliage d'apport de Sn-In-Ag constitué de

- entre 88 et 98,5 % en poids de Sn,
- entre 1 et 8 % en poids de In,
- entre 0,5 et 3,5 % en poids de Ag,
- entre 0 et 1 % en poids de Cu,
- entre 0 et 3 % en poids de Ga, Sb, Bi au total,
- jusqu'à 1 % en poids d'additifs sous forme de Ni, Fe, Co, Mn, Cr, Mo ou Ge ou d'impuretés,
- et un dopage avec un modificateur de cristallisation empêchant la croissance de phases intermétalliques dans l'apport solidifié sous forme de < 100 ppm de néodyme.

**2.** Métal d'apport de brasage tendre selon la revendication 1, **caractérisé en ce qu'**il présente entre 1,5 et 5 % en poids d'indium.

**3.** Métal d'apport de brasage tendre selon une des revendications 1 ou 2, **caractérisé en ce qu'**il présente entre 1 et 3 % en poids d'argent.

**4.** Métal d'apport de brasage tendre selon une des revendications 1 à 3, **caractérisé en ce qu'**il présente une température de fusion supérieure à 210°C.

**5.** Métal d'apport de brasage tendre selon une des revendications 1 à 4, **caractérisé en ce que** la formation de phases de $Ag_3Sn$ s'effectue en forme d'étoile avec sollicitation en température.

**6.** Métal d'apport de brasage tendre selon une des revendications 1 à 5, **caractérisé en ce que** le modificateur de cristallisation est dissous dans la matrice.

**7.** Procédé de fabrication d'un métal d'apport de brasage tendre selon une des revendications 1 à 6, **caractérisé en ce que** du Nd avec un des constituants de l'apport de Sn-In-Ag est produit en tant que préalliage qui est dilué dans les constituants résiduels.

**8.** Utilisation d'un métal d'apport de brasage tendre selon une des revendications 1 à 6 dans la technique de connexion par billes.

**9.** Utilisation d'une brasure provenant d'un métal d'apport de brasage tendre selon une des revendications 1 à 3 à des températures d'utilisation comprises entre 140 et 200°C, notamment entre 150 et 190°C.

Grenzflächenaufbau nach Temperaturlagerung:

Ausbildung der Ag₃Sn Phasen

Fig. 1

Ag₃Sn ohne Modifier

Ag₃Sn

Mit Kristallmodifier Nd

20 um

20 µm

Ag₃Sn

Fig. 2

Fig. 3

Fig. 4

Ag$_3$Sn Phasen wachsen aus der Lötstelle:

Querschliff

Fig.5

Kupfer-Substrat gelagert 175°C / 120h

# Fig. 6

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5938862 A
- DE 102004050441 A1
- EP 1623791 A2
- WO 03051572 A
- WO 03051572 A1
- WO 9743456 A
- CN 1346728 A